(19) Europäisches Patentamt
European Patent Office
Office européen des brevets

(11) **EP 2 063 280 A1**

(12) **EUROPEAN PATENT APPLICATION**
published in accordance with Art. 153(4) EPC

(43) Date of publication:
**27.05.2009 Bulletin 2009/22**

(51) Int Cl.:
***G01R 31/36*** (2006.01)

(21) Application number: **07791802.7**

(86) International application number:
**PCT/JP2007/065122**

(22) Date of filing: **26.07.2007**

(87) International publication number:
**WO 2008/029572 (13.03.2008 Gazette 2008/11)**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK RS**

(30) Priority: **04.09.2006 JP 2006239037**

(71) Applicant: **Toyota Jidosha Kabushiki Kaisha Toyota-shi, Aichi 471-8571 (JP)**

(72) Inventor: **NISHI, Yuji Toyota-shi Aichi 471-8571 (JP)**

(74) Representative: **TBK-Patent Bavariaring 4-6 80336 München (DE)**

(54) **SECONDARY BATTERY INTERNAL STATE ESTIMATING APPARATUS AND SECONDARY BATTERY INTERNAL STATE ESTIMATING METHOD**

(57) By using a battery model capable of estimating the internal reaction of a secondary battery (10) based on a parameter value, a battery model portion (60) provides the battery model with the parameter value obtained from a parameter generating portion (62) and estimates the internal state of the secondary battery (10). The parameter generating portion (62) generates the parameter value including a material property value of the secondary battery (10), based on information indicating a usage state of the secondary battery (10). The battery model is updated by updating the parameter value. This reduces a difference between the actual internal state of the secondary battery and the internal state of the secondary battery estimated by the battery model.

FIG.5

## Description

Technical Field

The present invention relates to an internal state estimating device for a secondary battery and a method for estimating an internal state of a secondary battery. More particularly, the present invention relates to a device and a method for estimating an internal state of a secondary battery in accordance with a battery model.

Background Art

Various methods for estimating a state of a secondary battery have been proposed in the past. For example, Japanese Patent Laying-Open No. 2003-346919 discloses a method for estimating State of Charge (SOC) of a secondary battery. According to this method, an ion concentration distribution in active materials forming a lithium ion battery is first calculated based on a value of a current flowing into a storage battery. Next, an open-circuit voltage of a power storage device is calculated based on the calculated ion concentration distribution. Then, SOC is estimated based on the open-circuit voltage.

In the above method, material property values of the secondary battery are modeled. Specifically speaking, it is assumed that the active materials are spherically-shaped in the above method. Furthermore, it is assumed that the ion concentration is distributed in a radial direction of the sphere and the ion concentration distribution is uniform in a circumferential direction.

According to the above method, a change in the material property values due to a degree of deterioration of the lithium ion battery is not taken into consideration, and therefore, SOC or the like may not be able to be accurately calculated depending on the degree of deterioration. Japanese Patent Laying-Open No. 2003-346919, however, does not disclose a specific solution to such a problem.

Moreover, a deterioration state of the secondary battery varies depending on an environment where the secondary battery is used. According to a conventional equivalent-circuit-based method for estimating SOC, information about the capacity of the battery and the internal resistance of the battery can be obtained. A value of the internal resistance and a rate of change due to deterioration, however, vary depending on a measurement method.

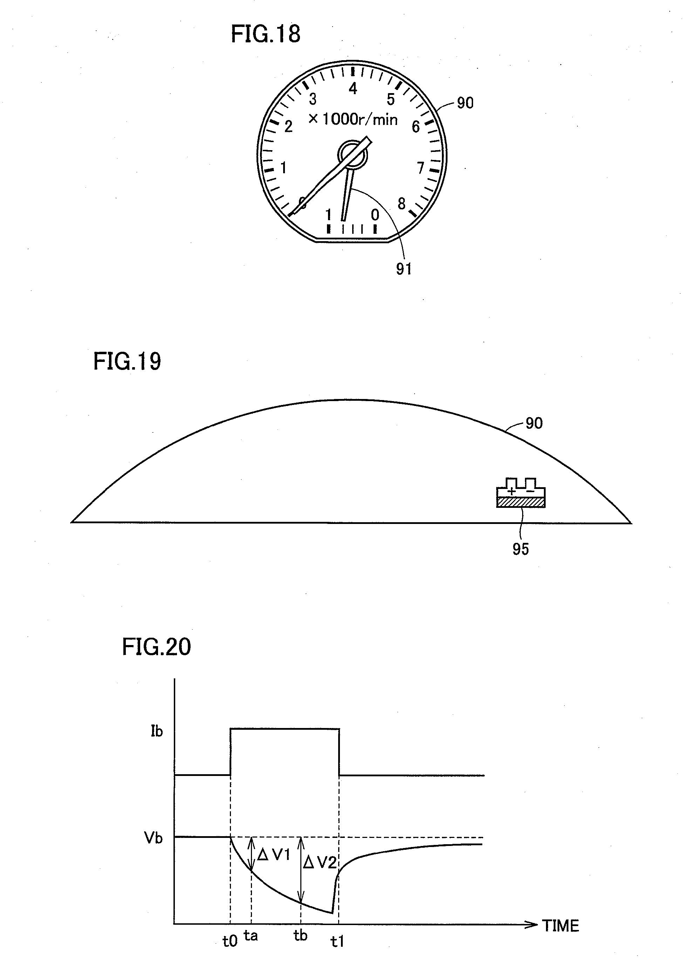

Fig. 20 shows a difference in an internal resistance of the secondary battery due to a difference in a measurement method.

Referring to Fig. 20, the secondary battery outputs a constant battery current Ib in a pulsed manner during times t0 to t2. A battery output voltage Vb is decreased during times t0 to t1, and is gradually recovered after the pulsed current is interrupted (that is, after time t1).

"$\Delta V1$" and "$\Delta V2$" indicate amounts of decrease in battery output voltage Vb at times ta and tb, respectively. As shown in Fig. 20, even if the current is constant, $\Delta V1$ is different from $\Delta V2$ in magnitude. Therefore, the internal resistance (= $\Delta V2/Ib$) of the battery at time ta is different from the internal resistance ($\Delta V2/Ib$) at time tb.

Moreover, in a case where the capacity is decreased, the internal resistance value varies depending on the deterioration state even if SOC is the same. Thus, an internal state of the secondary battery cannot be estimated with high accuracy by the conventional estimation methods.

Disclosure of the Invention

An object of the present invention is to provide an internal state estimating device for a secondary battery capable of estimating an internal state of the secondary battery with a high degree of precision, and a method for estimating an internal state of a secondary battery.

In summary, the present invention is directed to an internal state estimating device for a secondary battery, including a parameter generating portion and an internal state estimating portion. The parameter generating portion generates a parameter value including a material property value of the secondary battery, based on information indicating a usage state of the secondary battery. The internal state estimating portion estimates an internal state of the secondary battery, by using a battery model capable of estimating an internal reaction of the secondary battery based on the parameter value and providing the battery model with the parameter value obtained from the parameter generating portion.

Preferably, the internal state estimating device for a secondary battery further includes a sensor detecting an output of the secondary battery and outputting a detected value as information indicating a usage state of the secondary battery. The internal state estimating portion calculates a predicted value of the output of the secondary battery based on the estimated internal state of the secondary battery. The parameter generating portion includes a parameter estimating portion estimating the parameter value such that the detected value is equal to the predicted value, and a parameter storage portion storing the parameter value, updating the parameter value stored, based on an estimation result of the parameter estimating portion, and providing the parameter value updated to the internal state estimating portion.

More preferably, the internal state estimating device for a secondary battery further includes a deterioration characteristic storage portion and a deterioration estimating portion. The deterioration characteristic storage portion stores a standard deterioration characteristic of the parameter value with respect to a degree of use of the secondary battery in advance. The deterioration estimating portion estimates a deterioration state of the secondary battery based on the deterioration characteristic and the updated parameter value that is the parameter value updated by the parameter updating portion.

More preferably, the deterioration estimating portion sets the parameter value obtained based on a degree of use of the secondary battery when the parameter value is updated and the deterioration characteristic to a standard value of the updated parameter value, and in addition, compares the standard value and the updated parameter value and determines whether or not the secondary battery is more deteriorated than a secondary battery in a standard usage state.

More preferably, the internal state estimating device for a secondary battery further includes a display portion displaying a determination result of the deterioration estimating portion.

More preferably, a limit value of the parameter value is set in advance for the deterioration characteristic. The deterioration estimating portion finds a difference in a degree of use between the limit value and the updated parameter value based on the deterioration characteristic, and estimates the difference in a degree of use as a remaining lifetime of the secondary battery.

More preferably, the internal state estimating device for a secondary battery further includes a display portion displaying the remaining lifetime.

Preferably, the secondary battery includes a lithium ion battery. The material property value includes ion conductivity, electron conductivity in a solid layer, a diffusion coefficient of an active material, and reaction resistance.

According to another aspect of the present invention, a method for estimating an internal state of a secondary battery includes the steps of: generating a parameter value including a material property value of the secondary battery, based on information indicating a usage state of the secondary battery; and estimating an internal state of the secondary battery, by using a battery model capable of estimating an internal reaction of the secondary battery based on the parameter value and providing the battery model with the parameter value generated in the step of generating the parameter value.

Preferably, the method for estimating an internal state of a secondary battery further includes the step of detecting an output of the secondary battery by using a sensor provided for the secondary battery, and outputting a value detected by the sensor as information indicating a usage state of the secondary battery, wherein, in the step of estimating an internal state of the secondary battery, a predicted value of the output of the secondary battery is calculated based on the estimated internal state of the secondary battery. The step of generating the parameter value includes the steps of: estimating the parameter value such that the detected value is equal to the predicted value; and updating the parameter value stored in advance, based on an estimation result of the parameter value.

More preferably, the method for estimating an internal state of a secondary battery further includes the step of estimating a deterioration state of the secondary battery based on a standard deterioration characteristic of the parameter value with respect to a degree of use of the secondary battery and an updated parameter value that is the parameter value updated in the step of updating the parameter value.

More preferably, in the step of estimating a deterioration state of the secondary battery, the parameter value obtained based on a degree of use of the secondary battery when the parameter value is updated and the deterioration characteristic is set to a standard value of the updated parameter value, and in addition, the standard value and the updated parameter value are compared and it is determined whether or not the secondary battery is more deteriorated than a secondary battery in a standard usage state.

More preferably, the method for estimating an internal state of a secondary battery further includes the step of displaying a determination result in the step of estimating a deterioration state of the secondary battery.

More preferably, a limit value of the parameter value is set in advance for the deterioration characteristic. In the step of estimating the deterioration state, a difference in a degree of use between the limit value and the updated parameter value is found based on the deterioration characteristic, and the difference in a degree of use is estimated as a remaining lifetime of the secondary battery.

More preferably, the method for estimating an internal state of a secondary battery further includes the step of displaying the remaining lifetime.

Preferably, the secondary battery includes a lithium ion battery. The material property value includes ion conductivity, electron conductivity in a solid layer, a diffusion coefficient of an active material, and reaction resistance.

Therefore, according to the present invention, an internal state of a secondary battery can be estimated with high accuracy.

Brief Description of the Drawings

Fig. 1 is a schematic block diagram illustrating a configuration example of a power supply system including an internal state estimating device for a secondary battery according to an embodiment of the present invention and a secondary battery.

Fig. 2 is a conceptual view of a schematic configuration of a secondary battery 10.

Fig. 3 is a conceptual view illustrating the modeling of the secondary battery in a battery model portion 60.

Fig. 4 shows variables and constants used in a battery model in tabular form.

Fig. 5 is a functional block diagram of an internal state estimating device for a secondary battery according to a first embodiment.

Fig. 6 is a flowchart illustrating an estimation process by the internal state estimating device for a battery according to the first embodiment.

Fig. 7 is a functional block diagram of an internal state estimating device for a secondary battery according to a second embodiment.

Fig. 8 is a conceptual diagram illustrating a process of estimating a deterioration state of the secondary battery by a deterioration characteristic storage portion 82 and a deterioration estimating portion 84 in Fig. 7.

Fig. 9 is a flowchart illustrating a process of estimating the deterioration state performed by the internal state estimating device for a secondary battery according to the second embodiment.

Fig. 10 is a configuration diagram of a power supply system including an internal state estimating device for a secondary battery according to a third embodiment.

Fig. 11 is a functional block diagram of the internal state estimating device for a secondary battery according to the third embodiment.

Fig. 12 is a conceptual diagram illustrating deterioration determination of the secondary battery according to the third embodiment.

Fig. 13 is a flowchart illustrating a process of displaying the deterioration state performed by the internal state estimating device for a secondary battery according to the third embodiment.

Fig. 14 is a conceptual diagram illustrating remaining lifetime estimation of a secondary battery according to a fourth embodiment.

Fig. 15 is a flowchart illustrating a process of estimating the remaining lifetime performed by an internal state estimating device for a secondary battery according to the fourth embodiment.

Fig. 16 shows a hardware configuration example of an ECU 50.

Fig. 17 is a block diagram illustrating a configuration of a hybrid vehicle having the internal state estimating device for a secondary battery according to the embodiments of the present invention mounted thereon.

Fig. 18 shows an example of a display of an estimation result of the internal state of the secondary battery.

Fig. 19 shows another example of a display of an estimation result of the internal state of the secondary battery.

Fig. 20 shows a difference in an internal resistance of the secondary battery due to a difference in a measurement method.

Best Modes for Carrying Out the Invention

In the following, the embodiments of the present invention will be described in detail with reference to the figures. It is noted that, in the following, the same or corresponding parts in the figures will be denoted with the same reference characters and the description thereof is basically not repeated.

[First Embodiment]

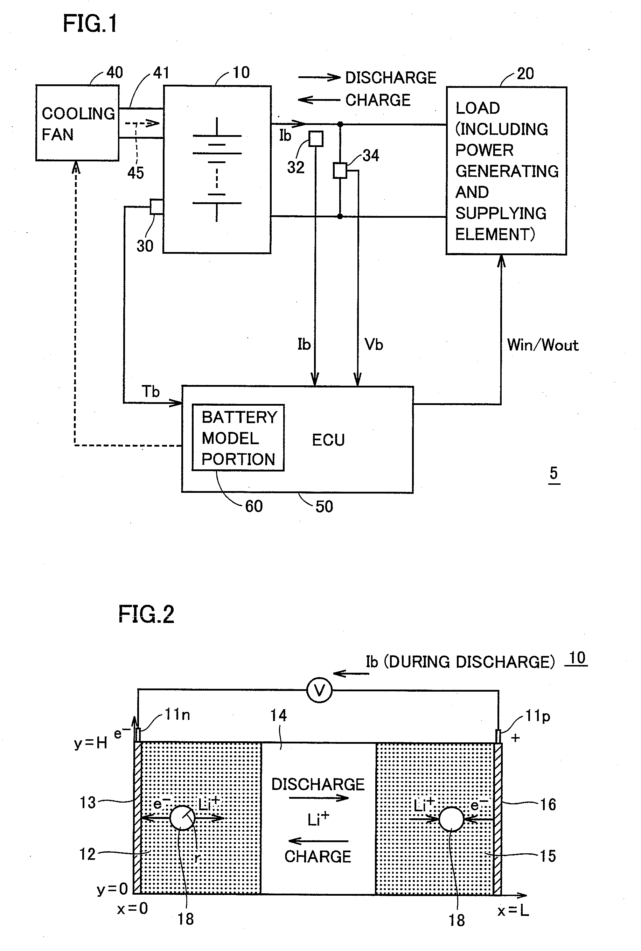

Fig. 1 is a schematic block diagram illustrating a configuration example of a power supply system including an internal state estimating device for a secondary battery according to an embodiment of the present invention and a secondary battery.

Referring to Fig. 1, a power supply system 5 includes a secondary battery 10, a load 20, a cooling fan 40 for the secondary battery, and an Electronic Control Unit (ECU) 50.

Typically, a lithium ion battery is used as rechargeable secondary battery 10. Lithium ion batteries are suitably adopted for the present invention, because their output characteristic varies depending on the distribution state of lithium ion concentration in the interior of the battery.

Secondary battery 10 is provided with a temperature sensor 30 measuring a battery temperature Tb, a current sensor 32 measuring input/output current Ib (also referred to as battery current Ib hereinafter) of secondary battery 10, and a voltage sensor 34 measuring a terminal-to-terminal voltage Vb (also referred to as battery output voltage Vb hereinafter) between the positive electrode and the negative electrode.

Cooling fan 40 is connected to secondary battery 10 through a coolant passage 41 to supply cooling air 45 to coolant passage 41. Although not shown, secondary battery 10 is provided with a coolant channel as appropriate so that each cell of secondary battery 10 can be cooled by cooling air 45 supplied through coolant passage 41. The actuation/termination of cooling fan 40 and the coolant supply rate during operation are controlled by ECU 50.

Load 20 is driven by an output voltage from secondary battery 10. Furthermore, a not-shown power generating and supplying element is provided to be included in load 20 or is provided separately from load 20, so that secondary battery 10 can be charged by a charging current from the power generation/feeding element. Therefore, during discharge of secondary battery 10, battery current $Ib > 0$, and during charge of secondary battery 10, battery current $Ib < 0$.

ECU 50 is configured to include a battery model portion 60 estimating an internal state of secondary battery 10 in accordance with a battery model capable of dynamically estimating the internal state of secondary battery 10 based on detected values from sensors 30, 32, 34 provided for secondary battery 10. Furthermore, ECU 50 calculates an outputtable power (discharging power upper limit value) Wout and an inputtable power (charging power upper limit value) Win from secondary battery 10, based on an estimation result of battery model portion 60 (for example, SOC of secondary battery 10). ECU 50 sets Wout = 0 when discharge is prohibited, and sets Wout > 0 when discharge is allowed. Similarly, ECU 50 sets Win = 0 when charge is prohibited, and sets Win > 0 when charge is allowed.

Inputtable/outputtable power Win, Wout set by ECU 50 are sent to a control element of load 20. As a result, the operation of load 20 is limited within a range of this inputtable/outputtable power Win, Wout. It is noted that ECU 50 is typically formed of a microcomputer and a memory (RAM, ROM or the like) for executing prescribed sequences and prescribed operations programmed in advance.

Fig. 2 is a conceptual view of a schematic configuration of secondary battery 10. Referring to Fig. 2, secondary battery 10 includes a negative electrode 12, a separator 14 and a positive electrode 15. Separator 14 is formed by immersing a resin provided between negative electrode 12 and positive electrode 15 in electrolyte.

Each of negative electrode 12 and positive electrode 15 is formed of a collection of spherical active materials 18. On the interface of active material 18 of negative electrode 12, a chemical reaction occurs to emit a lithium ion Li$^+$ and an electron e$^-$. On the other hand, on the interface of active material 18 of positive electrode 15, a chemical reaction occurs to absorb a lithium ion Li$^+$ and an electron e$^-$.

Negative electrode 12 is provided with a current collector 13 absorbing electron e$^-$, and positive electrode 15 is provided with a current collector 16 emitting electron e$^-$. Current collector 13 of the negative electrode is typically formed of copper and current collector 16 of the positive electrode is typically formed of aluminum. Current collector 13 is provided with a negative electrode terminal 11n and current collector 16 is provided with a positive electrode terminal 11p. The transport of lithium ion Li$^+$ through separator 14 causes charge/discharge in secondary battery (battery cell) 10 to generate charging current ($Ib > 0$) or discharging current ($Ib < 0$).

Therefore, a state of charge/discharge in the interior of the secondary battery varies depending on the lithium ion concentration distribution in the electrodes (the positive electrode and the negative electrode).

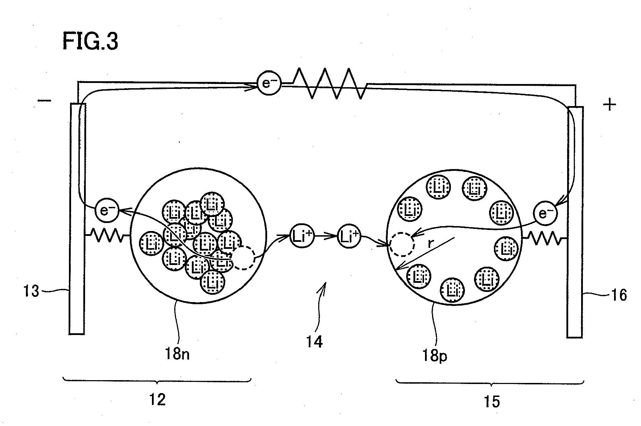

Fig. 3 is a conceptual view illustrating the modeling of the secondary battery in battery model portion 60.

Referring to Fig. 3, in a battery model equation, given that the behavior of lithium ion Li$^+$ in each active material 18 is common in each of negative electrode 12 and positive electrode 15 of secondary battery 10, it is assumed that one active material 18n and one active material 18p are representatively provided for negative electrode 12 and positive electrode 15, respectively.

During discharge, by the electrode reaction on the surface of negative electrode active material 18n, lithium atom Li in active material 18n becomes lithium ion Li$^+$ due to emission of electron e$^-$ and is then emitted to the electrolyte in separator 14. On the other hand, in the electrode reaction on the surface of positive electrode active material 18p, the lithium ion Li$^+$ in the electrolyte is taken in and electron e$^-$ is absorbed. Accordingly, lithium atom Li is taken into the interior of positive electrode active material 18p. The emission of lithium ion Li$^+$ from negative electrode active material 18n and take-in of lithium ion Li$^+$ at positive electrode active material 18p causes current to flow from current collector 16 of the positive electrode to current collector 13 of the negative electrode.

By contrast, during discharge of the secondary battery, by the electrode reaction on the surface of negative electrode active material 18n, lithium ion Li$^+$ in the electrolyte is taken in, and in the electrode reaction on the surface of positive electrode active material 18p, lithium ion Li$^+$ is emitted into the electrolyte.

In the battery model equations, the electrode reaction on the surface of active materials 18p, 18n during charge/discharge, diffusion (radial direction) of lithium ions in the interior of active materials 18p, 18n, diffusion of lithium ions in the electrolyte, and the potential distribution at each part are modeled.

In the following, an example of the battery model capable of dynamically estimating the internal state of the secondary battery for use in battery model portion 60 will be described. The battery model is configured with battery model equations (M1)-(M15).

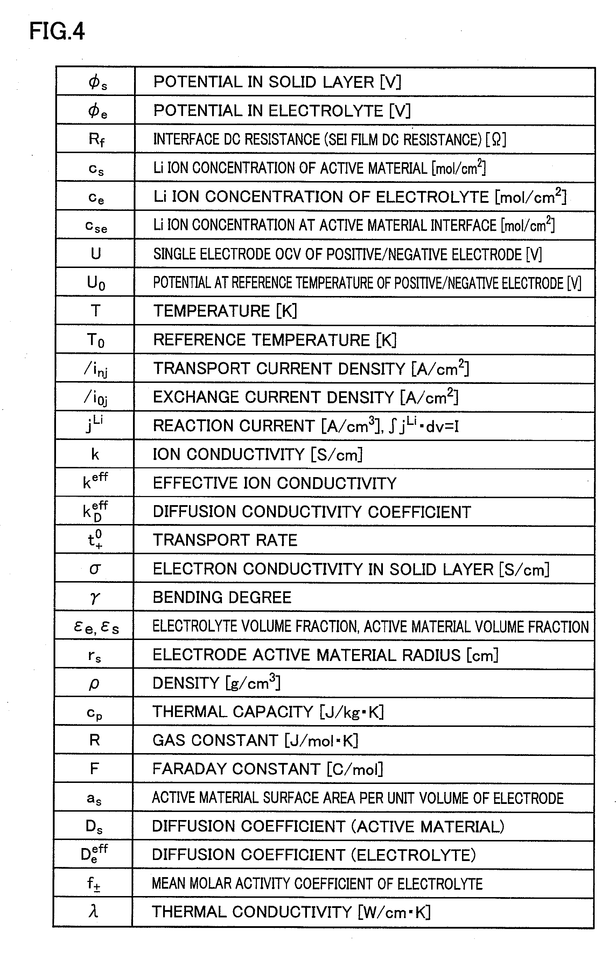

Fig. 4 shows variables and constants used in the battery model in tabular form.

Fig. 4 shows a listing of variables and constants used in the battery model equations (M1)-(M15) below. It is noted that a parameter value input to the battery model includes ion concentration of the active material, electron conductivity in a solid layer, a diffusion coefficient of the active material, and reaction resistance (or exchange current density) among various material property values shown in Fig. 4. It is noted that the reaction resistance and the exchange current density are reciprocal to each other.

$$/i_n = i_o \left[ \exp\left( \frac{\alpha_j F}{RT} \eta \right) - \exp\left( -\frac{\alpha_c F}{RT} \eta \right) \right] \qquad \cdots (M1)$$

$$\eta = \phi_s - \phi_e - U - /i_n R_f \qquad \cdots (M2)$$

$$U = U_0 + (T - T_0)\frac{\delta U}{\delta T} \qquad \cdots (M3)$$

Equations (M1)-(M3) are equations called Butler-Volmer equations, which indicate electrode reaction. In equation (M1), exchange current density $i_0$ is given by a function of a lithium ion concentration at the interface of active material 18. It is noted that the details of the following description is explained, for example, in "THERMAL-ELECTROCHEMICAL COUPLED MODELING OF A LITHIUM-ION CELL" written by W. B. Guand and C. Y. Wang (ECS Proceedings Vol. 99-25(1), 2000, publishing country: USA, publisher: Electrochemical Society (ECS), year of publication: 2000, corresponding pages: pp 743-762).
In equation (M2), the detail of $\eta$ in equation (M1) is shown, and in equation (M3), the detail of U in equation (M2) is shown.

$$\frac{\delta(\varepsilon_e c_e)}{\delta t} = \nabla(D_e^{eff} \nabla c_e) + \frac{1 - t_+^o}{F} j^{Li} - \frac{\vec{i}_e \nabla t_+^o}{F} \qquad \cdots (M4)$$

$$D_e^{eff} = \frac{D_e \varepsilon_e}{\tau} \qquad \cdots (M5)$$

$$j^{Li} = a_s \cdot /i_n \qquad \cdots (M6)$$

Equations (M4)-(M6) show the law of conservation of lithium ion in the electrolyte. Equation (M5) shows the definition of the effective diffusion coefficient in the electrolyte, and equation (M6) shows that reaction current $j^{Li}$ is given by the product of active material surface area $a_s$ per unit volume of the electrode and transport current density $/i_{nj}$ shown in equation (M1). Here, the volume integral for the entire electrode of reaction current $j^{Li}$ corresponds to battery current Ib.

$$\frac{\delta(\varepsilon_s c_s)}{\delta t} = \nabla D_s \nabla c_s \simeq D_s \left[ \frac{\delta^2 c_s}{\delta r^2} + \frac{2}{r}\frac{\delta c_s}{\delta r} \right] \qquad \cdots (M7)$$

$$a_s = \frac{3\varepsilon_s}{r_s} \qquad \cdots (M8)$$

Equations (M7) and (M8) show the law of conservation of lithium ion in the solid state. Equation (M7) shows the diffusion equation in spherical active material 18, and equation (M8) shows active material surface area $a_s$ per unit volume of the electrode.

$$\nabla(\kappa^{eff}\nabla\phi_e) + \nabla(\kappa_D^{eff}\nabla\ln c_e) + j^{Li} = 0 \qquad \cdots (M9)$$

$$\kappa^{eff} = \frac{\kappa}{\tau} \qquad \cdots (M10)$$

$$\kappa_D^{eff} = \frac{2RT\kappa^{eff}}{F}(t_+^o - 1)\left(1 + \frac{d\ln f\pm}{d\ln c_e}\right) \qquad \cdots (M11)$$

In equations (M9)-(M11), the equation indicating a potential in the electrolyte is derived from the law of conservation of charge in the electrolyte.
Equation (M10) shows effective ion conductivity $\kappa^{eff}$, and equation (M11) shows diffusion conductivity coefficient $\kappa_D^{eff}$ in the electrolyte.

$$\nabla(\sigma^{eff}\nabla\phi_s) - j^{Li} = 0 \qquad \cdots (M12)$$

$$\sigma^{eff} = \varepsilon_s\sigma \qquad \cdots (M13)$$

Equations (M12) and (M13) show the equations for finding a potential in the solid state by the law of conservation of charge in the active material.

$$\frac{\delta(\rho c_p T)}{\delta t} = \nabla\lambda\nabla T + q \qquad \cdots (M14)$$

$$q = a_s/i_n\left(\phi_s - \phi_e - U + T\frac{\delta U}{\delta T}\right) + \sigma^{eff}\nabla\phi_s\nabla\phi_s$$

$$+ \left(\kappa^{eff}\nabla\phi_e\nabla\phi_e + \kappa_D^{eff}\nabla\ln c_e\nabla\phi_e\right) \qquad \cdots (M15)$$

In equations (M14) and (M15), thermal energy conservation law is expressed. This enables analysis of a local temperature change into the interior of the secondary battery resulting from charge/discharge phenomenon.
It is noted that these battery model equations (M1)-(M15) are based on the aforementioned document, and the detailed explanation of each model equation is described in the aforementioned document.

By sequentially solving the difference equations with the boundary conditions set as appropriate at active materials 18p, 18n and each point in the electrolyte, in the battery model equations of equations (M1)-(M15), each variable shown in Fig. 4 is sequentially calculated, so that the temporal change of the battery state reflective of the internal reaction of the secondary battery can be estimated. Here, the lithium ion concentration in each active material 18p, 18n is a function of a radius r inside the active material and the lithium ion concentration is uniform in the circumferential direction.

In the aforementioned battery model, SOC is found by the number of lithium atoms in negative electrode active material 18n. Furthermore, estimation of the lithium ion concentration distribution in the interior of active materials 18p, 18n enables prediction of the battery state reflective of charge/discharge history in the past. For example, even if the present SOC is the same, the output voltage is relatively less likely to be decreased in a case where the current SOC is achieved by charge, followed by discharge than in a case where the current SOC is achieved by discharge, followed by further discharge. Here, prediction of such phenomenon is possible. Specifically, while the lithium ion concentration in negative electrode active material 18n is relatively high on the surface side immediately after charge, the lithium ion concentration in negative electrode active material 18n is relatively decreased on the surface side during discharge. Thus, the prediction as described above becomes possible, which reflects the lithium ion concentration distribution in the active material.

It is noted that SOC may be found, given that an electric double layer exists between active materials 18p, 18n and the electrolyte in order to enhance the precision of operation for SOC.

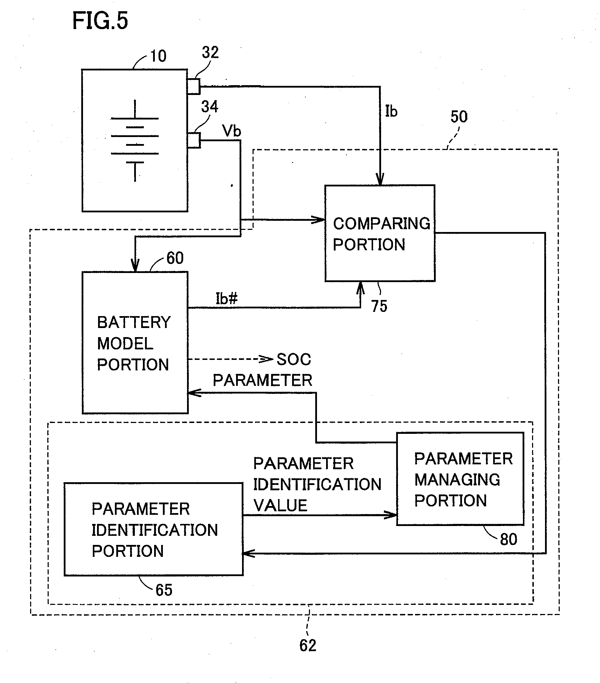

Fig. 5 is a functional block diagram of an internal state estimating device for a secondary battery according to a first embodiment.

Referring to Fig. 5, the internal state estimating device for a secondary battery according to the first embodiment includes voltage sensor 34 and ECU 50. ECU 50 includes battery model portion 60, a parameter generating portion 62 and a comparing portion 75. Parameter generating portion 62 includes a parameter identification portion 65 and a parameter managing portion 80.

By using a battery model capable of estimating the internal reaction of secondary battery 10 based on a parameter value, battery model portion 60 provides the battery model with the parameter value obtained from parameter generating portion 62 and estimates the internal state of secondary battery 10. More specifically, battery model portion 60 obtains the parameter value including a material property value of the secondary battery from parameter managing portion 80. A value detected by voltage sensor 34 is input to the battery model defining the internal state based on this parameter value. Battery model portion 60 uses the battery model to estimate SOC, and in addition, predicts a current that is to be output from secondary battery 10, based on the battery model. The predicted result of the current that is to be output from secondary battery 10 is output from battery model portion 60 as a predicted current Ib#.

Comparing portion 75 compares an actual battery output current Ib detected by current sensor 32 and predicted current Ib#, and provides notification to parameter generating portion 62 if there is a large difference between the two.

If a value detected by current sensor 32 is input to battery model portion 60, battery model portion 60 can predict a voltage that is to be output from secondary battery 10. Therefore, comparing portion 75 may compare the predicted result (predicted voltage) output from battery model portion 60 and an actual battery output voltage Vb detected by voltage sensor 34, and provide notification to parameter generating portion 62 if there is a large difference between the two.

Parameter generating portion 62 generates the parameter value including a material property value of secondary battery 10, based on information indicating a usage state of secondary battery 10. More specifically, parameter generating portion 62 generates the parameter value based on actual battery output voltage Vb detected by voltage sensor 34. In other words, a value of battery output voltage Vb detected by voltage sensor 34 corresponds to "information based on a usage state of secondary battery 10." If a value detected by current sensor 32 is input to battery model portion 60, actual battery output current Ib detected by current sensor 32 corresponds to "information based on a usage state of secondary battery 10."

In a case where the parameter value is fixed without taking the usage state of secondary battery 10 into consideration, the battery model can reflect only the internal state of the secondary battery at a certain point in time (for example, when the secondary battery is new). Therefore, as the secondary battery continues to be used, the precision of estimation of SOC or the like is decreased. In the present embodiment, the battery model is updated by updating the parameter based on the usage state of secondary battery 10. This reduces a difference between the actual internal state of the secondary battery and the internal state of the secondary battery estimated by the battery model, and therefore, SOC or the like can be estimated with high accuracy.

Parameter generating portion 62 includes parameter identification portion 65 and parameter managing portion 80. It is noted that parameter identification portion 65 and parameter managing portion 80 correspond to "parameter estimating portion" and "parameter updating portion" in the present invention, respectively.

Parameter identification portion 65 optimizes (identifies) the parameter value such that battery output current Ib matches predicted current Ib# (or the difference between the two is minimized). Parameter identification portion 65 optimizes the parameter value, for example, by using the Kalman filter theory to estimate the most probable parameter value. It is noted that parameter identification portion 65 may use other optimization methods (for example, the least squares method or the like) to estimate an optimum parameter value.

Parameter managing portion 80 manages (stores) the parameter value used in the battery model. Parameter managing portion 80 receives the parameter value identified by parameter identification portion 65 (parameter identification value) and updates the stored parameter value. Parameter managing portion 80 provides the stored parameter value to battery model portion 60. As a result, the parameter value input to battery model portion 60 is updated as appropriate.

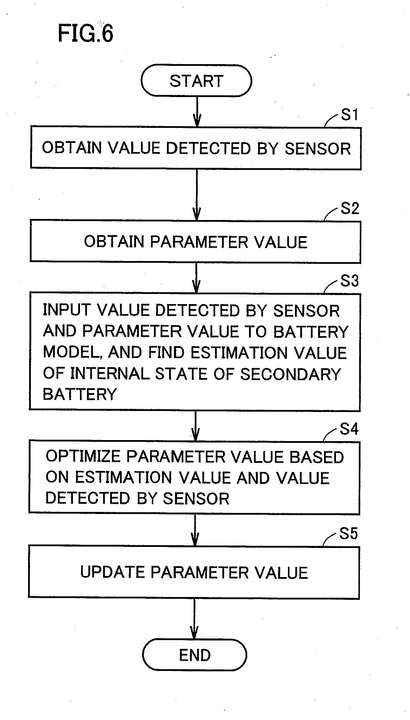

Fig. 6 is a flowchart illustrating an estimation process by the internal state estimating device for a battery according to the first embodiment.

Referring to Figs. 6 and 5, when a process starts, voltage sensor 34 detects a voltage of secondary battery 10 in step S1. Battery model portion 60 obtains a value detected by voltage sensor 34.

Next, in step S2, battery model portion 60 obtains a parameter value from parameter managing portion 80.

Then, in step S3, battery model portion 60 inputs the value detected by the sensor and the parameter value to the battery model and finds an estimated value of the internal state of secondary battery 10 (SOC of secondary battery 10 and predicted current Ib#).

Then, in step S4, parameter identification portion 65 optimizes the parameter value based on a difference between predicted current Ib# and battery output current Ib. As a result, a parameter value for reflecting a deterioration state of the secondary battery in the battery model is generated.

Then, in step S5, parameter identification portion 65 inputs the optimized parameter value to parameter managing portion 80. As a result, the parameter value stored by parameter managing portion 80 is updated. Therefore, the parameter value obtained by battery model portion 60 in step S2 becomes a parameter generated based on the usage state of secondary battery 10.

Thus, according to the first embodiment, the internal state of the secondary battery can be estimated with high accuracy, so that the maximum battery performance can be offered during use of the secondary battery. Furthermore, according to the first embodiment, electric power can be extracted from the secondary battery as much as possible, so that the battery can be reduced in size.

[Second Embodiment]

In a second embodiment, the deterioration state of the secondary battery is estimated based on the parameter value after update, in addition to the update of the parameter value based on the usage state of the secondary battery.

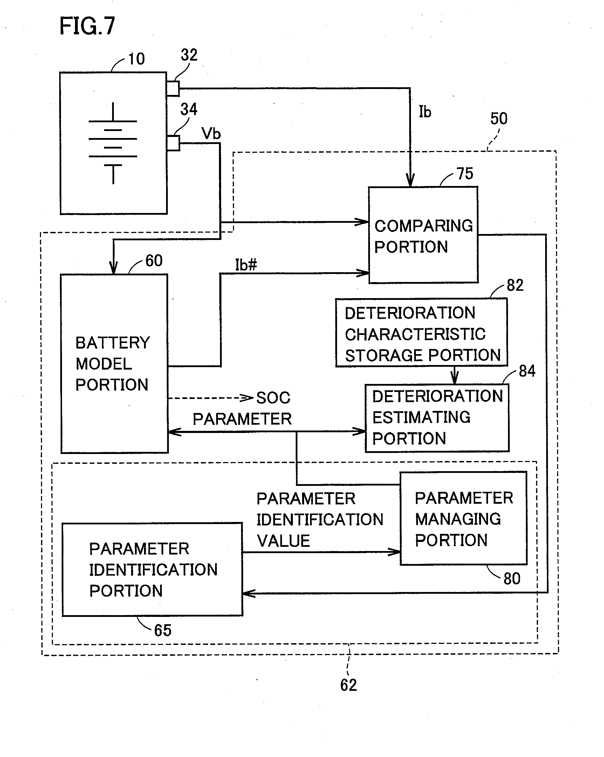

Fig. 7 is a functional block diagram of an internal state estimating device for a secondary battery according to the second embodiment.

Referring to Fig. 7, the internal state estimating device for a secondary battery according to the second embodiment includes voltage sensor 34 and ECU 50.

ECU 50 includes battery model portion 60, parameter generating portion 62 and comparing portion 75. Parameter generating portion 62 includes parameter identification portion 65 and parameter managing portion 80.

ECU 50 further includes a deterioration characteristic storage portion 82 and a deterioration estimating portion 84.

Deterioration characteristic storage portion 82 stores a standard deterioration characteristic of the parameter value with respect to a degree of use of secondary battery 10 in advance. Deterioration estimating portion 84 estimates the deterioration state of secondary battery 10 based on the deterioration characteristic of the parameter value stored by deterioration characteristic storage portion 82 and the parameter value updated by parameter managing portion 80 (the updated parameter value).

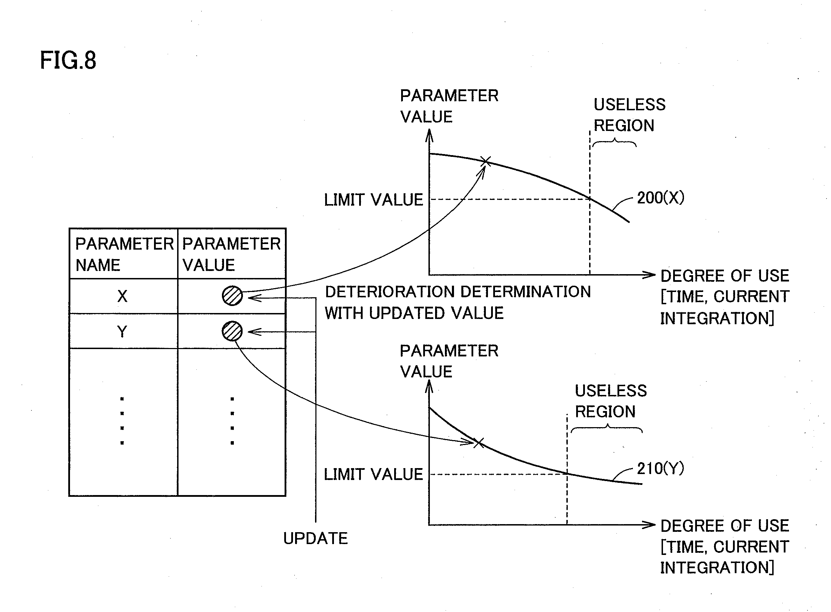

Fig. 8 is a conceptual diagram illustrating a process of estimating the deterioration state of the secondary battery by deterioration characteristic storage portion 82 and deterioration estimating portion 84 in Fig. 7.

Referring to Fig. 8, for the parameter to be updated, a change in parameter value in accordance with the degree of use of the secondary battery, namely, the deterioration characteristic is obtained in advance. Specifically, the parameter to be updated includes lithium ion concentration of the active material, electron conductivity in a solid layer, a diffusion coefficient of the active material, and reaction resistance (or exchange current density), and these are denoted as X and Y by way of example in Fig. 8.

A use time or a charging/discharging current integrated value is used as the degree of use of the secondary battery. In particular, in a case where the secondary battery subjected to charge/discharge control in accordance with the present invention is mounted on a vehicle such as a hybrid vehicle, a travel distance can be used as the degree of use of the battery.

As shown in Fig. 8, with respect to parameter X to be updated, a deterioration characteristic line 200 is obtained in advance, and a deterioration characteristic line 210 for parameter Y is obtained in advance. For deterioration characteristic lines 200, 210, a limit value for the parameter is obtained in advance. If the parameter value changes (decreases or increases) beyond the limit value, it can be determined that it is in a useless region.

When the parameter is updated, the degree of use of the secondary battery, namely, the deterioration state of the secondary battery can be estimated based on the parameter value at the time of the update and the deterioration characteristic line.

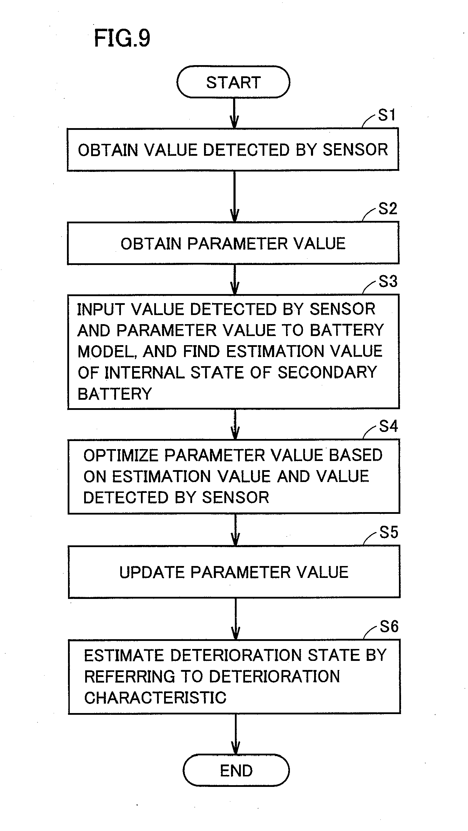

Fig. 9 is a flowchart illustrating a process of estimating the deterioration state performed by the internal state estimating device for a secondary battery according to the second embodiment.

In the flowchart shown in Fig. 9, step S6 is added after step S5 of the flowchart shown in Fig. 6. The processes in steps S1-S5 shown in Fig. 8 are similar to those in steps S1-S5 shown in Fig. 6, respectively. Therefore, in the following, the description of the processes in steps S1-S5 will not be repeated and only a process in step S6 will be described.

In step S6, deterioration estimating portion 84 uses the updated parameter value obtained from parameter managing portion 80 and the deterioration characteristic (deterioration characteristic lines 200, 210 in Fig. 8) stored in deterioration characteristic storage portion 82 to estimate the deterioration state of the secondary battery shown in Fig. 8.

As described above, according to the second embodiment, the parameter value input to the battery model is updated based on the usage state of the secondary battery, and the deterioration state is obtained by referring to the parameter after update and the deterioration characteristic of the parameter. As a result, the deterioration state of the secondary battery can be estimated with high accuracy. Furthermore, the maximum battery performance can be offered during use of the secondary battery.

[Third Embodiment]

In a third embodiment, the parameter value after update and a parameter value on the deterioration curve are compared, in addition to the update of the parameter value. Furthermore, in the third embodiment, a comparison result is displayed. As a result, a user of the secondary battery can grasp whether or not the secondary battery is more deteriorated than usual.

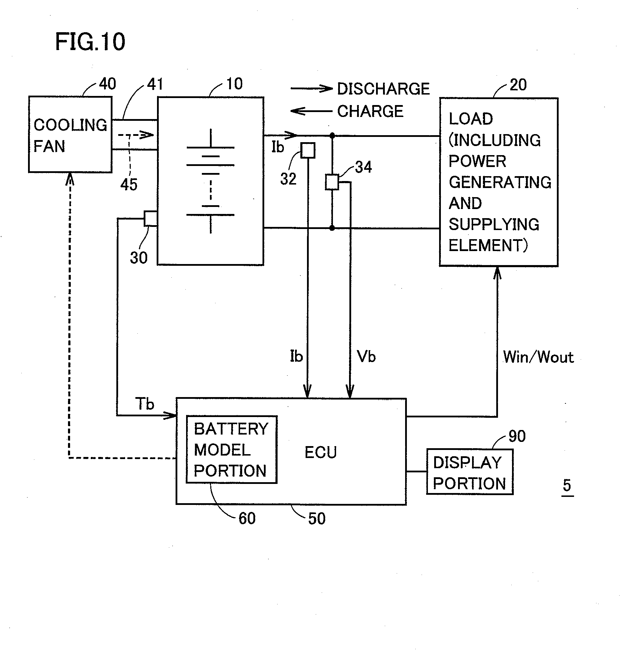

Fig. 10 is a configuration diagram of a power supply system including an internal state estimating device for a secondary battery according to the third embodiment.

Referring to Fig. 10, power supply system 5 includes secondary battery 10, load 20, cooling fan 40 for the secondary battery, ECU50, and a display portion 90. Display portion 90 receives information about the internal state of the secondary battery from ECU 50, and displays the information.

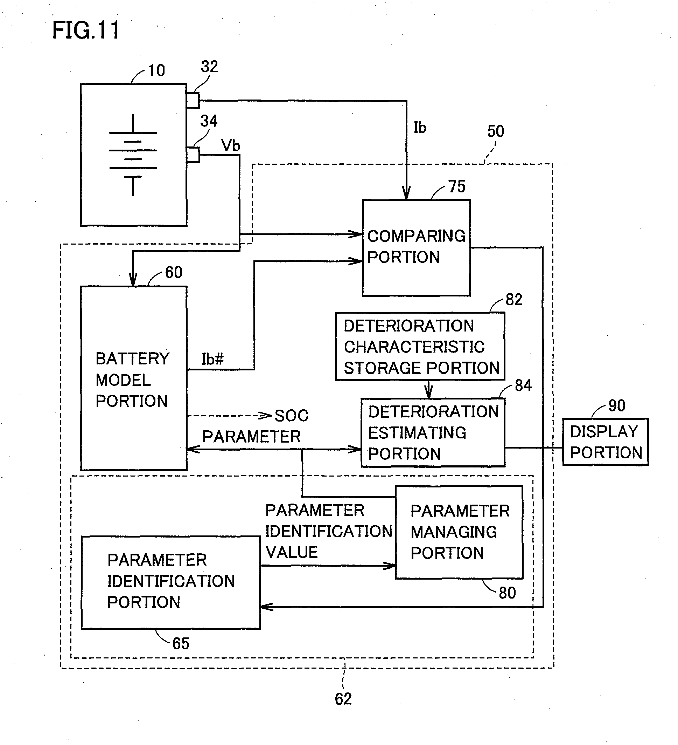

Fig. 11 is a functional block diagram of the internal state estimating device for a secondary battery according to the third embodiment.

Referring to Fig. 11, the internal state estimating device for a secondary battery according to the third embodiment includes voltage sensor 34, ECU 50 and display portion 90.

ECU 50 includes battery model portion 60, parameter generating portion 62 and comparing portion 75. Parameter generating portion 62 includes parameter identification portion 65 and parameter managing portion 80.

ECU 50 further includes deterioration characteristic storage portion 82 and deterioration estimating portion 84. Display portion 90 displays information received from deterioration estimating portion 84.

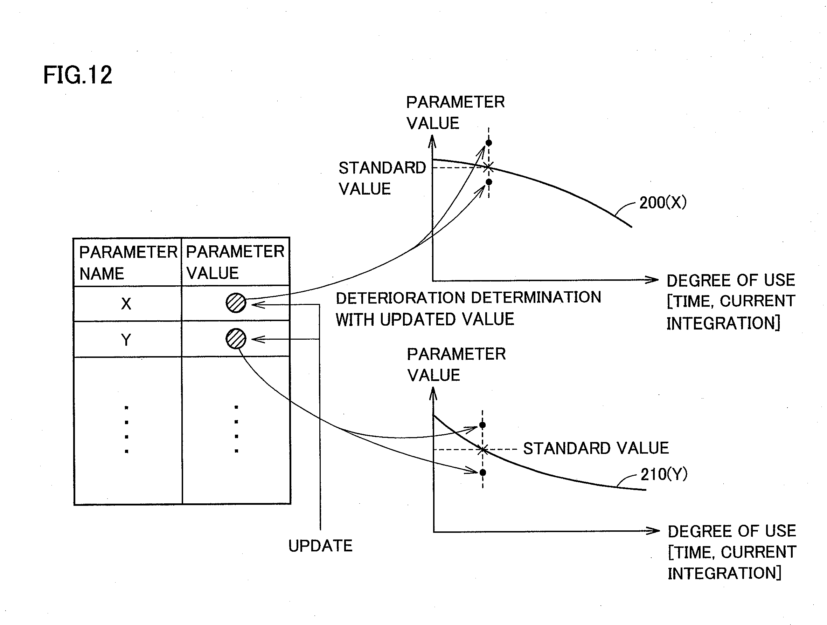

Fig. 12 is a conceptual diagram illustrating deterioration determination of the secondary battery according to the third embodiment.

Referring to Fig. 12, for the parameter to be updated, the deterioration characteristic is obtained in advance, as in the second embodiment.

Deterioration estimating portion 84 finds a standard value of the updated parameter value (a parameter value on the deterioration characteristic line) based on the degree of use of the secondary battery when the parameter value is updated, and the deterioration characteristic. Deterioration estimating portion 84 compares the standard value and the updated parameter value, and determines whether or not the secondary battery is more deteriorated than a secondary battery in a standard usage state. Display portion 90 displays a determination result received from deterioration estimating portion 84.

Correct comparison result between the updated parameter value and the parameter value on the deterioration characteristic line can be achieved by updating a parameter input to the battery model in accordance with the usage state of the secondary battery. Therefore, the deterioration condition of the secondary battery can be estimated with high accuracy.

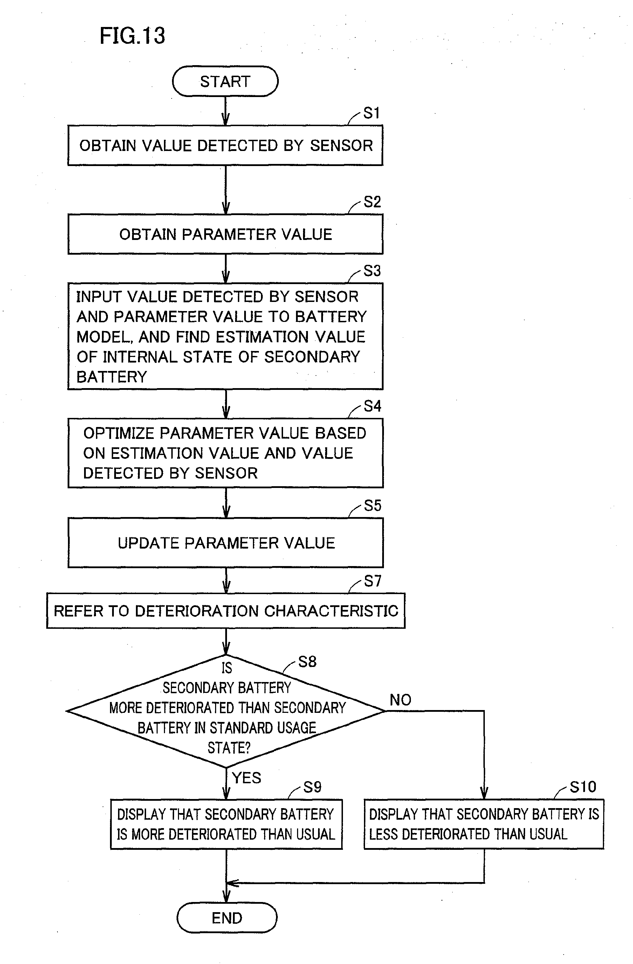

Fig. 13 is a flowchart illustrating a process of displaying the deterioration state performed by the internal state estimating device for a secondary battery according to the third embodiment.

In the flowchart shown in Fig. 13, processes in steps S7-S10 are added after the process in step S5 of the flowchart shown in Fig. 6. The processes in steps S1-S5 of the flowchart shown in Fig. 13 are the same as those in steps S1-S5 of the flowchart shown in Fig. 6, respectively. Therefore, in the following, only the processes in steps S7-S10 will be described.

In step S7, deterioration estimating portion 84 refers to the deterioration characteristic stored in deterioration characteristic storage portion 82. In step S8, deterioration estimating portion 84 compares the updated parameter value and the parameter value on the deterioration characteristic line corresponding to the parameter, and determines whether or not the secondary battery is more deteriorated than a secondary battery in the standard usage state.

The process in step S8 will be described with reference to Figs. 12 and 11. For example, if the updated value of parameter X is higher than the value on deterioration characteristic line 200, deterioration estimating portion 84 determines that secondary battery 10 is more deteriorated than a secondary battery in the standard usage state. On the other hand, if the updated value of parameter X is lower than the value on deterioration characteristic line 200, deterioration estimating portion 84 determines that secondary battery 10 is less deteriorated than a secondary battery in the standard usage state.

Returning again to Fig. 13, in a case where deterioration estimating portion 84 determines that the secondary battery is more deteriorated than a secondary battery in the standard usage state (YES in step S8), deterioration estimating portion 84 sends a first determination result to display portion 90. In step S9, display portion 90 displays that the secondary battery is more deteriorated than a secondary battery in a normal usage state (in the standard usage state), based on the first determination result.

On the other hand, in a case where deterioration estimating portion 84 determines that the secondary battery is less deteriorated than a secondary battery in the standard usage state (NO in step S8), deterioration estimating portion 84 sends a second determination result to display portion 90. In step S 10, display portion 90 displays that the secondary battery is less deteriorated than a secondary battery in the normal usage state, based on the second determination result.

Thus, according to the third embodiment, the deterioration state of the battery is displayed, so that convenience for users can be enhanced.

For example, in a case where the internal state estimating device for a secondary battery is mounted on a vehicle of a hybrid vehicle or the like, a driver can grasp the deterioration condition of the secondary battery. Moreover, in a case where the hybrid vehicle having the internal state estimating device for a secondary battery mounted thereon is sold as a used car, a sales price of the car can be set based on the deterioration condition of the secondary battery. In addition, the deterioration condition of the battery can be displayed when a person who wants to buy the used car buys the car, which can prevent him/her from worrying about the deterioration condition of the battery.

[Fourth Embodiment]

In a fourth embodiment, the remaining lifetime of the secondary battery is estimated based on the parameter value after update. Moreover, the estimated remaining lifetime is displayed in the fourth embodiment.

It is noted that a configuration of a power supply system including an internal state estimating device for a secondary battery according to the fourth embodiment is similar to that of the power supply system shown in Fig. 10. Furthermore, a configuration of functional blocks of the internal state estimating device for a secondary battery according to the fourth embodiment is similar to that of the functional blocks shown in Fig. 11.

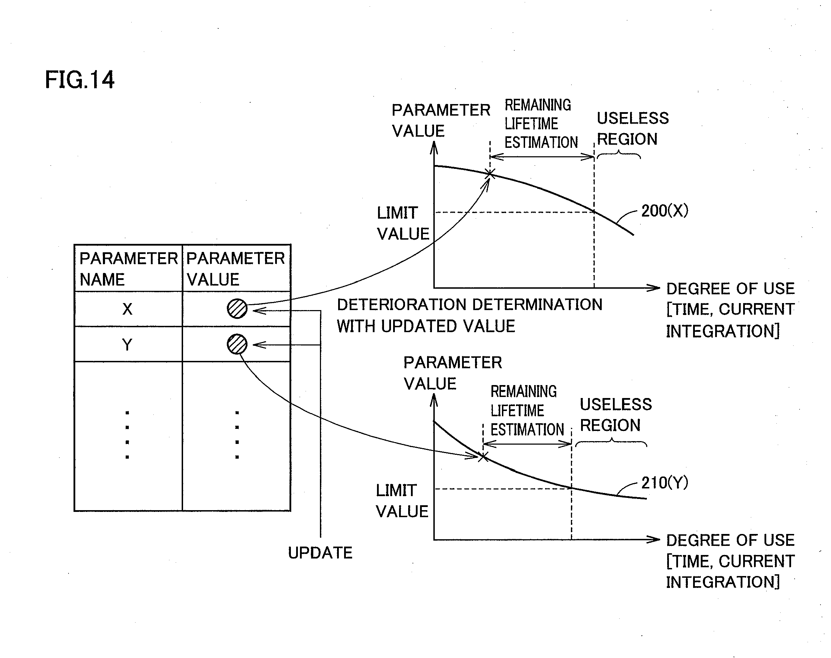

Fig. 14 is a conceptual diagram illustrating remaining lifetime estimation of the secondary battery according to the fourth embodiment.

Referring to Fig. 14, for the parameter to be updated, the deterioration characteristic is obtained in advance, as in the second and third embodiments.

For deterioration characteristic lines 200, 210, a limit value for the parameter is obtained in advance. If the parameter value changes (decreases or increases) beyond the limit value, it can be determined that it is in a useless region. In this manner, the limit value for the parameter value is set in advance for the deterioration characteristic stored by deterioration characteristic storage portion 82.

Deterioration estimating portion 84 finds the degree of use corresponding to the updated value of the parameter, in accordance with the deterioration characteristic line. Then, deterioration estimating portion 84 finds a difference between the degree of use and a degree of use at the time of reaching the useless region, and estimates the difference as the remaining lifetime of the secondary battery. By using the updated parameter value to estimate the degree of use of the secondary battery, the degree of use of the secondary battery when the parameter value is updated can be estimated with high accuracy. Consequently, the remaining lifetime can also be estimated with high accuracy.

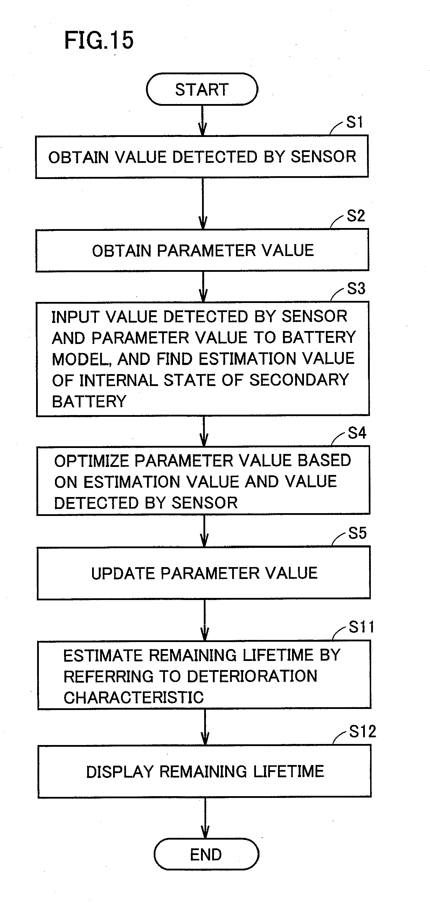

Fig. 15 is a flowchart illustrating a process of estimating the remaining lifetime performed by the internal state estimating device for a secondary battery according to the fourth embodiment.

In the flowchart shown in Fig. 15, processes in steps S11 and S12 are added after the process in step S5 of the flowchart shown in Fig. 6. The processes in steps S1-S5 of the flowchart shown in Fig. 15 are the same as those in steps S1-S5 of the flowchart shown in Fig. 6, respectively. Therefore, in the following, only the processes in steps S11 and S12 will be described.

Referring to Figs. 15 and 11, in step S11, deterioration estimating portion 84 refers to deterioration characteristic lines 200, 210. Then, deterioration estimating portion 84 estimates the remaining lifetime of the secondary battery based on the difference between the degree of use corresponding to the updated parameter value and the degree of use at the time of reaching the useless region.

Next, in step S12, parameter managing portion 80 causes display portion 90 to display information about the remaining lifetime.

Thus, according to the fourth embodiment, the remaining lifetime of the secondary battery is displayed, so that convenience for users can be enhanced, as in the third embodiment.

[Configuration Example of ECU]

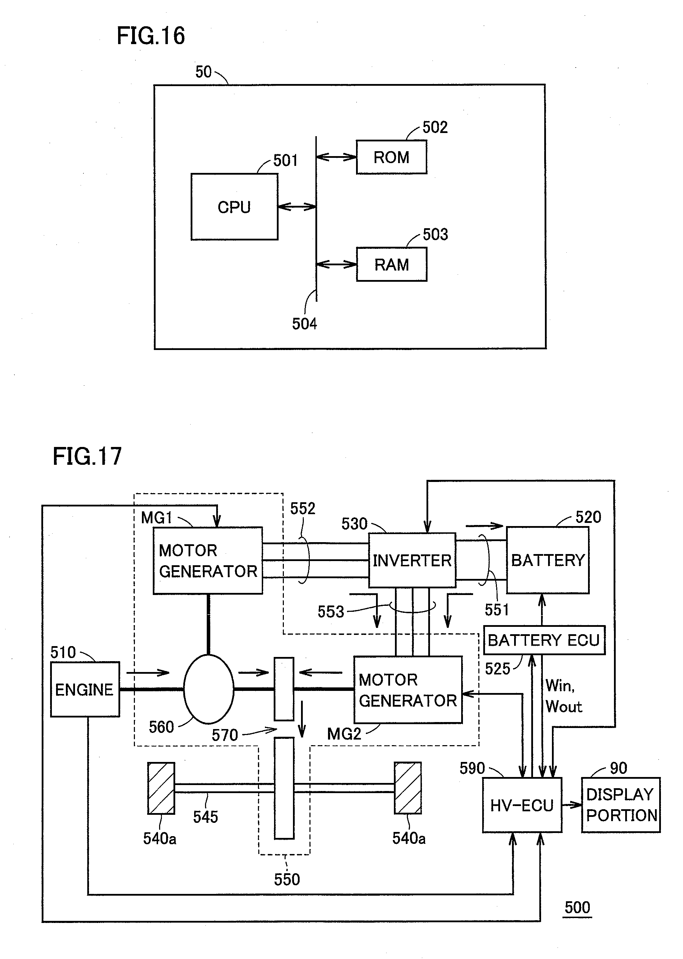

Fig. 16 shows a hardware configuration example of ECU 50.

Referring to Fig. 16, ECU 50 includes a CPU 501, a ROM 502, a RAM 503, and a bus 504. CPU 501 operates as an internal state estimating device for a secondary battery including the functional blocks shown in Figs. 5, 7 and the like by executing prescribed sequences and prescribed operations programmed in advance.

ROM 502 stores a program for causing CPU 501 to perform the estimation process, in a nonvolatile manner. RAM 503 temporarily stores data required at the time of the process by CPU 501. Exchange of data between CPU 501 and ROM 502 (or RAM 503) are performed via bus 504. Thus, ROM 502 corresponds to a computer (CPU501) readable storage medium on which a program including each step of the flowchart shown in any of Figs. 6, 9, 13 and 15 is recorded.

[Example for Mounting Secondary Battery]

The secondary battery and the internal state estimating device for a secondary battery described above can be mounted on a hybrid-drive vehicle 500, as shown in Fig. 17.

Fig. 17 is a block diagram illustrating a configuration of a hybrid vehicle having the internal state estimating device for a secondary battery according to the embodiments of the present invention mounted thereon.

Referring to Fig. 17, a hybrid-drive vehicle 500 includes an engine 510, a battery 520 controlled by a battery ECU 525, an inverter 530, wheels 540a, a transaxle 550, and an electronic control unit (HV-ECU) 590 controlling the entire operation of hybrid-drive vehicle 500. HV-ECU 590 and battery ECU 525 correspond to ECU 50 shown in Fig. 1 and the like.

Engine 510 generates a driving power using combustion energy of fuel such as gasoline as a source. Battery 520 supplies direct-current power to a power line 551. Battery 520 is typically formed of a lithium-ion secondary battery and is controlled by battery ECU 525. In other words, battery ECU 525 sets inputtable/outputtable power Win, Wout based on an estimation result of the battery model estimating the internal state of battery 520.

Inverter 530 converts the direct-current power supplied from battery 520 into alternating-current power, which is then output to a power line 553. Alternatively, inverter 530 converts alternating-current power supplied to power lines 552, 553 into direct-current power, which is then output to power line 551.

Transaxle 550 includes a transmission and an axle as an integrated structure and has a power split mechanism 560, a speed reducer 570, a motor generator MG1, and a motor generator MG2.

Power split mechanism 560 can divide the driving power generated by engine 510 into a transmission path to a drive shaft 545 for driving wheels 540a through speed reducer 570 and a transmission path to motor generator MG1.

Motor generator MG1 is rotated by the driving power from engine 510 transmitted through power split mechanism 560 to generate electric power. The electric power generated by motor generator MG1 is supplied to inverter 530 through power line 552 and used as charging power for battery 520 or driving power of motor generator MG2.

Motor generator MG2 is rotated and driven by the alternating-current power supplied from inverter 530 to power line 553. The driving power generated by motor generator MG2 is transmitted to drive shaft 545 through speed reducer 570. Furthermore, in a case where motor generator MG2 is rotated along with deceleration of wheels 540a during regenerative braking operation, electromotive force (alternating-current power) generated in motor generator MG2 is supplied to power line 553. In this case, inverter 530 converts the alternating-current power supplied to power line 553 into direct-current power for output to power line 551, thereby charging battery 520.

Although each of motor generators MG1, MG2 may function as a generator and as a motor, motor generator MG1 often operates as a generator in general, and motor generator MG2 often operates mainly as a motor.

HV-ECU 590 controls the entire operation of the equipment and circuitry mounted on the vehicle in order to allow hybrid-drive vehicle 500 to be driven according to an instruction by the driver. HV-ECU 590 is typically formed of a microcomputer and a memory (RAM, ROM or the like) for executing prescribed sequences and prescribed operations programmed in advance.

As described above, in hybrid-drive vehicle 500, with a combination of the driving power generated by engine 510 and the driving power driven by motor generator MG2 using the electric energy from battery 520 as a source, vehicle operation is performed with improved fuel efficiency.

For example, at start-up and at the time of low load during low-speed travel or during descent on a gentle slope, hybrid-drive vehicle 500 runs only with the driving power by motor generator MG2 basically without starting the engine, in order to avoid a region in which an engine efficiency is bad.

During normal travel, the driving power output from engine 510 is split into a driving power for wheels 540a and a driving power for electric power generation at motor generator MG1 by power split mechanism 560. The electric power generated by motor generator MG1 is used for driving motor generator MG2. Therefore, during normal travel, wheels 540a are driven with the driving power by engine 510 with the assistance of the driving power by motor generator MG2. ECU 590 controls the proportion of driving power sharing between engine 510 and motor generator MG2.

During full throttle acceleration, supply power from battery 520 is further used to drive the second motor generator MG2, thereby further increasing the driving power for wheels 540a.

During deceleration and braking, motor generator MG2 generates torque in the opposite direction to rotation of wheels 540a thereby to function as a generator performing regenerative power generation. Electric power recovered by regenerative power generation of motor generator MG2 is used to charge battery 520 through power line 553, inverter 530 and power line 551. Furthermore, at vehicle stop, engine 510 is automatically stopped.

In this way, distribution between engine 510 and motor generator MG2 for a required output power for the entire vehicle is determined depending on the drive situation. Specifically, HV-ECU 590 determines the above-noted distribution according to the drive situation, in consideration of the efficiency of engine 510 in terms of fuel efficiency.

At this time, output commands (or torque commands) for engine 510 and motor generator MG2 are generated such that battery 520 is charged/discharged within a range of inputtable/outputtable power Win, Wout set by battery ECU 525. As a result, a phenomenon that leads to local battery deterioration in the interior of battery 520 is avoided and the lifetime of battery 520 can be prolonged. Furthermore, determination of the remaining lifetime of battery 520 along with update of a parameter in the battery model equations is allowed.

In addition, estimation of the internal state of battery 520 is performed, for example, at the time of startup and termination of use of hybrid-drive vehicle 500.

Display portion 90 receives an estimation result of the internal state of the secondary battery from the HV-ECU, and displays the estimation result. A display example by display portion 90 will be described specifically in the following.

Fig. 18 shows an example of a display of an estimation result of the internal state of the secondary battery.

Referring to Fig. 18, display portion 90 is a tachometer. This tachometer is provided with a needle 91 for displaying the internal state of the secondary battery. The movement of needle 91 from a scale of "1" to "0" indicates that the lifetime of the secondary battery approaches the end. In other words, needle 91 displays the remaining lifetime of the secondary battery. It is noted that it may be displayed whether or not the secondary battery is more deteriorated than usual, depending on whether needle 91 moves to the right or to the left from the central position.

Fig. 19 shows another example of a display of an estimation result of the internal state of the secondary battery.

Referring to Fig. 19, display portion 90 is a meter on which a vehicle speed or a warning message is displayed. In this meter, a lamp 95 for displaying the remaining lifetime or the deterioration state of the battery lights up. A sequential change in color of lamp 95 from "blue," "yellow" to "red", for example, indicates that the remaining lifetime of the secondary battery is decreased. It is noted that it may be displayed whether or not the secondary battery is more deteriorated than usual by changing the color of lamp 95.

The internal state of the secondary battery can be displayed by various methods other than the display examples shown in Figs. 18 and 19. For example, an illumination color of the meter may be changed in accordance with the deterioration state or the like of the battery. Furthermore, the deterioration state or the like of the secondary battery may be displayed by a lighting color of the lamp when a button switch (for example, an ignition switch) with a lamp is turned on. In addition, in the case of the vehicle including a touch panel, a message may be displayed on the touch panel by the driver's operation of the touch panel.

Although the display examples that can be seen by the driver are shown in Figs. 18 and 19, a maintenance worker (or a dealer) may use a dedicated tool to allow display of the deterioration state or the remaining lifetime of the secondary battery, for example. Furthermore, the display methods according to the present embodiments may be a display method by voice.

It should be understood that the embodiments disclosed herein are illustrative and not limitative in any respect. The scope of the present invention is defined by the terms of the claims, rather than the description above, and is intended to include any modifications within the scope and meaning equivalent to the terms of the claims.

**Claims**

1. An internal state estimating device for a secondary battery, comprising:

   a parameter generating portion generating a parameter value including a material property value of said secondary battery, based on information indicating a usage state of the secondary battery; and

an internal state estimating portion estimating an internal state of said secondary battery, by using a battery model capable of estimating an internal reaction of said secondary battery based on said parameter value and providing said battery model with said parameter value obtained from said parameter generating portion.

2. The internal state estimating device for a secondary battery according to claim 1, further comprising

a sensor detecting an output of said secondary battery and outputting a detected value as information indicating a usage state of said secondary battery, wherein
said internal state estimating portion calculates a predicted value of the output of said secondary battery based on the estimated internal state of said secondary battery, and
said parameter generating portion includes

a parameter estimating portion estimating said parameter value such that said detected value is equal to said predicted value, and
a parameter storage portion storing said parameter value, updating said parameter value stored, based on an estimation result of said parameter estimating portion, and providing said parameter value updated to said internal state estimating portion.

3. The internal state estimating device for a secondary battery according to claim 2, further comprising:

a deterioration characteristic storage portion storing a standard deterioration characteristic of said parameter value with respect to a degree of use of said secondary battery in advance; and
a deterioration estimating portion estimating a deterioration state of said secondary battery based on said deterioration characteristic and the updated parameter value that is said parameter value updated by said parameter updating portion.

4. The internal state estimating device for a secondary battery according to claim 3, wherein
said deterioration estimating portion sets said parameter value obtained based on a degree of use of said secondary battery when said parameter value is updated and said deterioration characteristic to a standard value of said updated parameter value, and in addition, compares said standard value and said updated parameter value and determines whether or not said secondary battery is more deteriorated than a secondary battery in a standard usage state.

5. The internal state estimating device for a secondary battery according to claim 4, further comprising
a display portion displaying a determination result of said deterioration estimating portion.

6. The internal state estimating device for a secondary battery according to claim 3, wherein
a limit value of said parameter value is set in advance for said deterioration characteristic, and
said deterioration estimating portion finds a difference in a degree of use between said limit value and said updated parameter value based on said deterioration characteristic, and estimates said difference in a degree of use as a remaining lifetime of said secondary battery.

7. The internal state estimating device for a secondary battery according to claim 6, further comprising
a display portion displaying said remaining lifetime.

8. The internal state estimating device for a secondary battery according to claim 1, wherein
said secondary battery includes a lithium ion battery, and
said material property value includes
ion conductivity,
electron conductivity in a solid layer,
a diffusion coefficient of an active material, and
reaction resistance.

9. A method for estimating an internal state of a secondary battery, comprising the steps of:

generating a parameter value including a material property value of said secondary battery, based on information indicating a usage state of the secondary battery; and
estimating an internal state of said secondary battery, by using a battery model capable of estimating an internal reaction of said secondary battery based on said parameter value and providing said battery model with said parameter value generated in the step of generating said parameter value.

10. The method for estimating an internal state of a secondary battery according to claim 9, further comprising the step of detecting an output of said secondary battery by using a sensor provided for said secondary battery, and outputting a value detected by said sensor as information indicating a usage state of said secondary battery, wherein in the step of estimating an internal state of said secondary battery, a predicted value of the output of said secondary battery is calculated based on the estimated internal state of said secondary battery, and the step of generating said parameter value includes the steps of estimating said parameter value such that said detected value is equal to said predicted value, and updating said parameter value stored in advance, based on an estimation result of said parameter value.

11. The method for estimating an internal state of a secondary battery according to claim 10, further comprising the step of estimating a deterioration state of said secondary battery based on a standard deterioration characteristic of said parameter value with respect to a degree of use of said secondary battery as well as an updated parameter value that is said parameter value updated in the step of updating said parameter value.

12. The method for estimating an internal state of a secondary battery according to claim 11, wherein in the step of estimating a deterioration state of said secondary battery, said parameter value obtained based on a degree of use of said secondary battery when said parameter value is updated and said deterioration characteristic is set to a standard value of said updated parameter value, and in addition, said standard value and said updated parameter value are compared and it is determined whether or not said secondary battery is more deteriorated than a secondary battery in a standard usage state.

13. The method for estimating an internal state of a secondary battery according to claim 12, further comprising the step of displaying a determination result in the step of estimating a deterioration state of said secondary battery.

14. The method for estimating an internal state of a secondary battery according to claim 11, wherein a limit value of said parameter value is set in advance for said deterioration characteristic, and in the step of estimating said deterioration state, a difference in a degree of use between said limit value and said updated parameter value is found based on said deterioration characteristic, and said difference in a degree of use is estimated as a remaining lifetime of said secondary battery.

15. The method for estimating an internal state of a secondary battery according to claim 14, further comprising the step of displaying said remaining lifetime.

16. The method for estimating an internal state of a secondary battery according to claim 9, wherein said secondary battery includes a lithium ion battery, and said material property value includes ion conductivity, electron conductivity in a solid layer, a diffusion coefficient of an active material, and reaction resistance.

## FIG.1

## FIG.2

FIG.3

# FIG.4

| $\phi_s$ | POTENTIAL IN SOLID LAYER [V] |
|---|---|
| $\phi_e$ | POTENTIAL IN ELECTROLYTE [V] |
| $R_f$ | INTERFACE DC RESISTANCE (SEI FILM DC RESISTANCE) [$\Omega$] |
| $c_s$ | Li ION CONCENTRATION OF ACTIVE MATERIAL [mol/cm$^2$] |
| $c_e$ | Li ION CONCENTRATION OF ELECTROLYTE [mol/cm$^2$] |
| $c_{se}$ | Li ION CONCENTRATION AT ACTIVE MATERIAL INTERFACE [mol/cm$^2$] |
| U | SINGLE ELECTRODE OCV OF POSITIVE/NEGATIVE ELECTRODE [V] |
| $U_0$ | POTENTIAL AT REFERENCE TEMPERATURE OF POSITIVE/NEGATIVE ELECTRODE [V] |
| T | TEMPERATURE [K] |
| $T_0$ | REFERENCE TEMPERATURE [K] |
| $/i_{nj}$ | TRANSPORT CURRENT DENSITY [A/cm$^2$] |
| $/i_{0j}$ | EXCHANGE CURRENT DENSITY [A/cm$^2$] |
| $j^{Li}$ | REACTION CURRENT [A/cm$^3$], $\int j^{Li} \cdot dv = I$ |
| k | ION CONDUCTIVITY [S/cm] |
| $k^{eff}$ | EFFECTIVE ION CONDUCTIVITY |
| $k_D^{eff}$ | DIFFUSION CONDUCTIVITY COEFFICIENT |
| $t_+^0$ | TRANSPORT RATE |
| $\sigma$ | ELECTRON CONDUCTIVITY IN SOLID LAYER [S/cm] |
| $\gamma$ | BENDING DEGREE |
| $\varepsilon_e, \varepsilon_s$ | ELECTROLYTE VOLUME FRACTION, ACTIVE MATERIAL VOLUME FRACTION |
| $r_s$ | ELECTRODE ACTIVE MATERIAL RADIUS [cm] |
| $\rho$ | DENSITY [g/cm$^3$] |
| $c_p$ | THERMAL CAPACITY [J/kg·K] |
| R | GAS CONSTANT [J/mol·K] |
| F | FARADAY CONSTANT [C/mol] |
| $a_s$ | ACTIVE MATERIAL SURFACE AREA PER UNIT VOLUME OF ELECTRODE |
| $D_s$ | DIFFUSION COEFFICIENT (ACTIVE MATERIAL) |
| $D_e^{eff}$ | DIFFUSION COEFFICIENT (ELECTROLYTE) |
| $f_\pm$ | MEAN MOLAR ACTIVITY COEFFICIENT OF ELECTROLYTE |
| $\lambda$ | THERMAL CONDUCTIVITY [W/cm·K] |

# FIG.5

# FIG.6

```
            ┌─────────────┐
            │    START    │
            └──────┬──────┘
                   │              ╱S1
    ┌──────────────▼──────────────┐
    │ OBTAIN VALUE DETECTED BY SENSOR │
    └──────────────┬──────────────┘
                   │              ╱S2
    ┌──────────────▼──────────────┐
    │    OBTAIN PARAMETER VALUE    │
    └──────────────┬──────────────┘
                   │              ╱S3
    ┌──────────────▼──────────────┐
    │ INPUT VALUE DETECTED BY SENSOR │
    │ AND PARAMETER VALUE TO BATTERY │
    │ MODEL, AND FIND ESTIMATION VALUE │
    │ OF INTERNAL STATE OF SECONDARY │
    │ BATTERY                      │
    └──────────────┬──────────────┘
                   │              ╱S4
    ┌──────────────▼──────────────┐
    │ OPTIMIZE PARAMETER VALUE BASED │
    │ ON ESTIMATION VALUE AND VALUE │
    │ DETECTED BY SENSOR           │
    └──────────────┬──────────────┘
                   │              ╱S5
    ┌──────────────▼──────────────┐
    │    UPDATE PARAMETER VALUE    │
    └──────────────┬──────────────┘
                   │
            ┌──────▼──────┐
            │     END     │
            └─────────────┘
```

# FIG.7

# FIG.8

EP 2 063 280 A1

| PARAMETER NAME | PARAMETER VALUE |
|:---:|:---:|
| X | ⊘ |
| Y | ⊘ |
| ⋮ | ⋮ |

DETERIORATION DETERMINATION WITH UPDATED VALUE

UPDATE

PARAMETER VALUE

USELESS REGION

LIMIT VALUE

200(X)

DEGREE OF USE [TIME, CURRENT INTEGRATION]

PARAMETER VALUE

USELESS REGION

LIMIT VALUE

210(Y)

DEGREE OF USE [TIME, CURRENT INTEGRATION]

## FIG.9

```
          ┌─────────────┐
          │    START    │
          └──────┬──────┘
                 │            ╱ S1
      ┌──────────▼──────────────────┐
      │ OBTAIN VALUE DETECTED BY SENSOR │
      └──────────┬──────────────────┘
                 │            ╱ S2
      ┌──────────▼──────────────────┐
      │    OBTAIN PARAMETER VALUE     │
      └──────────┬──────────────────┘
                 │            ╱ S3
      ┌──────────▼──────────────────┐
      │ INPUT VALUE DETECTED BY SENSOR │
      │ AND PARAMETER VALUE TO BATTERY │
      │ MODEL, AND FIND ESTIMATION VALUE │
      │ OF INTERNAL STATE OF SECONDARY │
      │ BATTERY                        │
      └──────────┬──────────────────┘
                 │            ╱ S4
      ┌──────────▼──────────────────┐
      │ OPTIMIZE PARAMETER VALUE BASED │
      │ ON ESTIMATION VALUE AND VALUE  │
      │ DETECTED BY SENSOR             │
      └──────────┬──────────────────┘
                 │            ╱ S5
      ┌──────────▼──────────────────┐
      │    UPDATE PARAMETER VALUE     │
      └──────────┬──────────────────┘
                 │            ╱ S6
      ┌──────────▼──────────────────┐
      │ ESTIMATE DETERIORATION STATE BY │
      │ REFERRING TO DETERIORATION     │
      │ CHARACTERISTIC                 │
      └──────────┬──────────────────┘
                 │
          ┌──────▼──────┐
          │     END     │
          └─────────────┘
```

# FIG.10

# FIG.11

# FIG.12

PARAMETER
VALUE

STANDARD
VALUE

200(X)

| PARAMETER NAME | PARAMETER VALUE |
|---|---|
| X | ⊘ |
| Y | ⊘ |
| ⋮ | ⋮ |

DETERIORATION DETERMINATION
WITH UPDATED VALUE

DEGREE OF USE
[TIME, CURRENT
INTEGRATION]

PARAMETER
VALUE

STANDARD VALUE

210(Y)

UPDATE

DEGREE OF USE
[TIME, CURRENT
INTEGRATION]

## FIG.13

START

S1
OBTAIN VALUE DETECTED BY SENSOR

S2
OBTAIN PARAMETER VALUE

S3
INPUT VALUE DETECTED BY SENSOR AND PARAMETER VALUE TO BATTERY MODEL, AND FIND ESTIMATION VALUE OF INTERNAL STATE OF SECONDARY BATTERY

S4
OPTIMIZE PARAMETER VALUE BASED ON ESTIMATION VALUE AND VALUE DETECTED BY SENSOR

S5
UPDATE PARAMETER VALUE

S7
REFER TO DETERIORATION CHARACTERISTIC

S8
IS SECONDARY BATTERY MORE DETERIORATED THAN SECONDARY BATTERY IN STANDARD USAGE STATE?

NO

YES

S9
DISPLAY THAT SECONDARY BATTERY IS MORE DETERIORATED THAN USUAL

S10
DISPLAY THAT SECONDARY BATTERY IS LESS DETERIORATED THAN USUAL

END

# FIG.14

PARAMETER VALUE

REMAINING LIFETIME ESTIMATION

USELESS REGION

LIMIT VALUE

200(X)

DETERIORATION DETERMINATION
WITH UPDATED VALUE

DEGREE OF USE
[TIME, CURRENT
INTEGRATION]

| PARAMETER NAME | PARAMETER VALUE |
|---|---|
| X | ⊘ |
| Y | ⊘ |
| ⋮ | ⋮ |

PARAMETER VALUE

REMAINING LIFETIME ESTIMATION

USELESS REGION

LIMIT VALUE

210(Y)

DEGREE OF USE
[TIME, CURRENT
INTEGRATION]

UPDATE

EP 2 063 280 A1

# FIG.15

START

**S1** OBTAIN VALUE DETECTED BY SENSOR

**S2** OBTAIN PARAMETER VALUE

**S3** INPUT VALUE DETECTED BY SENSOR AND PARAMETER VALUE TO BATTERY MODEL, AND FIND ESTIMATION VALUE OF INTERNAL STATE OF SECONDARY BATTERY

**S4** OPTIMIZE PARAMETER VALUE BASED ON ESTIMATION VALUE AND VALUE DETECTED BY SENSOR

**S5** UPDATE PARAMETER VALUE

**S11** ESTIMATE REMAINING LIFETIME BY REFERRING TO DETERIORATION CHARACTERISTIC

**S12** DISPLAY REMAINING LIFETIME

END

## FIG.16

## FIG.17

## FIG.18

## FIG.19

## FIG.20

## INTERNATIONAL SEARCH REPORT

| | International application No. |
|---|---|
| | PCT/JP2007/065122 |

A. CLASSIFICATION OF SUBJECT MATTER
*G01R31/36(2006.01)i*

According to International Patent Classification (IPC) or to both national classification and IPC

B. FIELDS SEARCHED

Minimum documentation searched (classification system followed by classification symbols)
G01R31/36

Documentation searched other than minimum documentation to the extent that such documents are included in the fields searched
| Jitsuyo Shinan Koho | 1922-1996 | Jitsuyo Shinan Toroku Koho | 1996-2007 |
| Kokai Jitsuyo Shinan Koho | 1971-2007 | Toroku Jitsuyo Shinan Koho | 1994-2007 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 2000-100478 A (Matsushita Electric Industrial Co., Ltd.), 07 April, 2000 (07.04.00), Full text; all drawings & EP 987555 A2 & DE 69912709 D & US 6262577 B1 | 1-16 |
| A | JP 2004-191152 A (Matsushita Electric Industrial Co., Ltd.), 08 July, 2004 (08.07.04), Full text; all drawings (Family: none) | 1-16 |

☒ Further documents are listed in the continuation of Box C.   ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 30 October, 2007 (30.10.07) | 06 November, 2007 (06.11.07) |

| Name and mailing address of the ISA/ | Authorized officer |
|---|---|
| Japanese Patent Office | |
| Facsimile No. | Telephone No. |

Form PCT/ISA/210 (second sheet) (April 2007)

EP 2 063 280 A1

**INTERNATIONAL SEARCH REPORT**

<table>
<tr><td colspan="2">International application No.</td></tr>
<tr><td colspan="2">PCT/JP2007/065122</td></tr>
</table>

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2000-100479 A  (Matsushita Electric Industrial Co., Ltd.), 07 April, 2000 (07.04.00), Full text; all drawings & EP 987555 A2          & DE 69912709 D & US 6262577 B1 | 1-16 |

Form PCT/ISA/210 (continuation of second sheet) (April 2007)

33

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2003346919 A

### Non-patent literature cited in the description

- THERMAL-ELECTROCHEMICAL COUPLED MODELING OF A LITHIUM-ION CELL. **W. B. GUAND ; C. Y. WANG.** ECS Proceedings. Electrochemical Society, 2000, vol. 99-25, 743-762